# FASCICULE DE BREVET EUROPEEN

(11) **EP 2 937 703 B1**
(45) Date de publication et mention de la délivrance du brevet: **22.03.2017**
(21) Numéro de dépôt: 15156003.4
(22) Date de dépôt: 20.02.2015
(51) Int. Cl.: G01R 15/18

(54) **Dispositif de mesure d'au moins une grandeur électrique d'un courant destiné à circuler dans un appareil électrique, et ensemble comprenant un tel dispositif**
Vorrichtung zum Messen mindestens einer elektrischen Größe eines Stroms, der in einem Elektrogerät fließen soll, und Einheit, die eine solche Vorrichtung umfasst
Device for measuring at least one electric magnitude of a current intended to flow in an electrical appliance, and assembly comprising such a device

(30) Priorité: 24.04.2014 FR 1453707
(43) Date de publication de la demande: 28.10.2015
(73) Titulaire: Schneider Electric Industries SAS, 92500 Rueil-Malmaison (FR)
(72) Inventeur: Tian, Simon, 38050 Grenoble Cedex 09 (FR); Vigouroux, Didier, 38050 Grenoble Cedex 09 (FR); Neyret, Yannick, 38050 Grenoble Cedex 09 (FR)
(74) Mandataire: Lavoix

(56) Documents cités:
- WO-A1-2008/042483
- FR-A1- 2 990 759
- US-A- 6 018 239
- US-A1- 2005 253 573

## Description

La présente invention concerne un dispositif de mesure d'au moins une grandeur électrique d'un courant destiné à circuler dans un appareil électrique. L'invention concerne également un ensemble comprenant un appareil électrique et un tel dispositif de mesure conforme à l'invention.

Il est connu de fabriquer des dispositifs de mesure permettant de mesurer les grandeurs électriques d'un courant traversant un disjoncteur, ces dispositifs de mesure étant également appelés compteurs d'énergie électrique lorsqu'ils permettent de calculer en outre l'énergie électrique associée à un courant donné. Ainsi, le document FR 2 977 323 A1 décrit un module de mesure prévu pour des disjoncteurs de faible calibre et utilisable afin de remettre à jour une installation électrique existante. Ce module comprend des trous débouchants permettant de le monter autour d'au moins un conducteur électrique relié au disjoncteur. Par ailleurs, il est connu du document WO-2008/042483 A1 de fabriquer un module de mesure dont le capteur de courant ne recouvre pas complètement le conducteur. Cependant, avec un tel capteur, la mesure est sensible à un champ parasite latéral. D'autre part, le document EP 1 684 080 A1 révèle l'utilisation d'un capteur indépendant monté sur chaque phase, autoalimenté par le courant qui passe dans le conducteur et communiquant par radio la valeur du courant mesuré.

FR 2 990 759 A1 décrit un dispositif de mesure d'au moins une grandeur électrique d'un courant destiné à circuler dans un appareil électrique, le dispositif de mesure comprenant au moins un capteur de courant, le ou chaque capteur de courant étant adapté pour mesurer le courant circulant dans un conducteur électrique correspondant,

Ces différents systèmes de mesure mesurent des grandeurs électriques d'un courant circulant dans le disjoncteur en positionnant au moins un capteur courant autour d'au moins un conducteur électrique relié au disjoncteur. Le montage de tels dispositifs de mesure, se fait donc nécessairement en au moins deux étapes, une première étape consistant à fixer le ou les conducteurs électriques sur la ou chaque borne du disjoncteur, après les avoir passés au travers du module de mesure. Une deuxième étape consiste à fixer le module de mesure au disjoncteur. L'installation des modules de mesure, est donc relativement complexe, peut induire des erreurs de montage et peut être rendue difficile par manque de place.

C'est à ces inconvénients qu'entend plus particulièrement remédier l'invention en proposant un dispositif de mesure d'au moins une grandeur électrique d'un courant destiné à circuler dans un appareil électrique, qui soit plus facile à assembler avec l'appareil électrique.

A cet effet, l'invention concerne un dispositif de mesure d'au moins une grandeur électrique d'un courant destiné à circuler dans un appareil électrique, l'appareil électrique comprenant au moins une borne de connexion, la ou chaque borne de connexion étant destinée à être reliée électriquement à l'extrémité d'un conducteur électrique correspondant, le dispositif de mesure comprenant au moins un capteur de courant, le ou chaque capteur de courant étant adapté pour mesurer le courant circulant dans un conducteur électrique correspondant. Ce dispositif de mesure comprend en outre au moins une entretoise électriquement conductrice, la ou chaque entretoise étant adaptée pour être interposée entre une borne de connexion respective et l'extrémité d'un conducteur électrique correspondant, et en ce que chaque capteur de courant est en outre disposé autour d'une entretoise respective, pour mesurer le courant circulant à travers ladite entretoise, entre le conducteur électrique et la borne de connexion correspondante.

Grâce à l'invention, le dispositif de mesure est facile à assembler à l'appareil électrique et convient à tout type de section du conducteur électrique.

Selon d'autres aspects avantageux et facultatifs de l'invention, un tel dispositif de mesure comporte une ou plusieurs des caractéristiques techniques suivantes, prises isolément ou selon toute combinaison techniquement possible :
- l'appareil électrique comprend N bornes de connexion, N étant un nombre entier supérieur ou égal à 2, et dans lequel le dispositif de mesure comprend N capteurs de courant et N entretoises ;
- au moins un capteur de courant comporte un circuit magnétique et une bobine, la bobine étant disposée entre deux extrémités du circuit magnétique ;
- les circuits magnétiques sont formés par une unique pièce en forme de boustrophédon ;
- au moins un capteur de courant comporte un enroulement bobiné en forme de tore, tel qu'un tore de Rogowski ;
- le dispositif de mesure comprend au moins un capteur de tension adapté pour mesurer la tension d'une borne de connexion correspondante ;
- le ou chaque capteur de tension est en forme d'une languette disposée contre une entretoise respective ;
- chaque entretoise comporte un orifice de passage d'un organe de connexion de l'extrémité du conducteur à la borne de connexion correspondante ;
- le dispositif comprend des moyens radioélectriques de transmission de la ou des grandeurs électriques mesurées, à un équipement électronique distant dudit dispositif; et
- le dispositif comporte des moyens d'emboîtage élastique avec des moyens complémentaires de l'appareil électrique, pour fixer le dispositif à l'appareil électrique.

L'invention concerne également un ensemble comprenant un appareil électrique et un dispositif de mesure tel que défini ci-dessus.

Selon d'autres aspects avantageux et facultatifs de l'invention, un tel ensemble comporte une ou plusieurs des caractéristiques techniques suivantes, prises isolément ou selon toute combinaison techniquement possible :
- l'appareil électrique est un appareil de coupure électrique ou de protection électrique ; et
- l'appareil électrique est un disjoncteur électrique.

L'invention sera mieux comprise et d'autres avantages de celle-ci apparaîtront à la lecture de la description qui va suivre, donnée uniquement à titre d'exemple non limitatif et faite en référence aux dessins annexés sur lesquels :
- la figure 1 est une vue en perspective de dessus d'un ensemble comprenant un disjoncteur et un dispositif de mesure conforme à un premier mode de réalisation de l'invention ;
- la figure 2 est une vue en perspective de dessus du dispositif de mesure de la figure 1, le dispositif comportant notamment un capot de protection ;
- la figure 3 est une vue en perspective éclatée du dispositif de mesure de la figure 1 ;
- la figure 4 est une vue en perspective du dessus du dispositif de la figure 1 dépourvu de son capot de protection ;
- la figure 5 est une vue de dessous du dispositif de la figure 1 ;
- la figure 6 est une vue analogue à celle de la figure 4 selon un deuxième mode de réalisation de l'invention ;
- la figure 7 est une vue analogue à celle de la figure 2 selon un troisième mode de réalisation;
- la figure 8 est une vue analogue à celle de la figure 4 selon le troisième mode de réalisation;
- la figure 9 est une vue analogue à celle de la figure 3 selon le troisième mode de réalisation;
- la figure 10 est une vue analogue à celle de la figure 4 selon un quatrième mode de réalisation de l'invention.

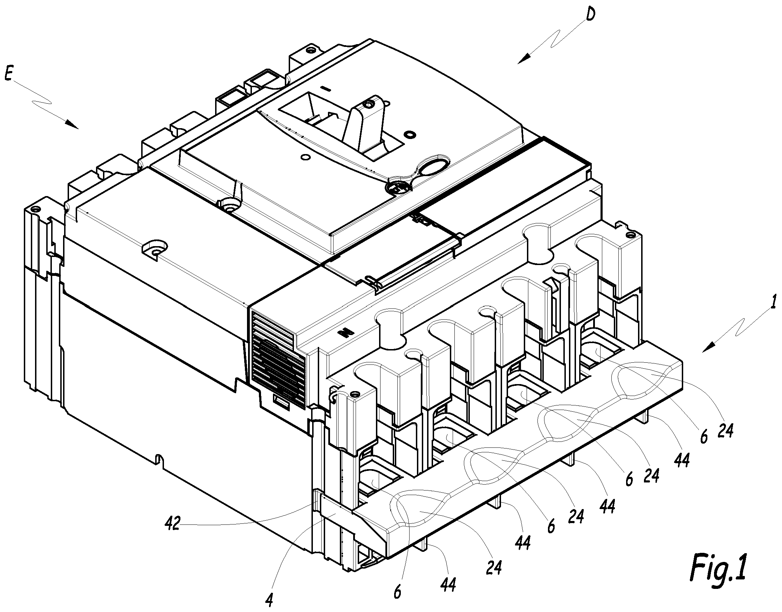

L'invention concerne un dispositif de mesure 1, adapté à être monté à un appareil électrique. Dans l'exemple de réalisation de l'invention décrit ci-après, l'appareil électrique est un disjoncteur D tétrapolaire, comportant quatre bornes de connexion. Un ensemble E formé du dispositif de mesure 1 monté sur le disjoncteur D est représenté sur la figure 1.

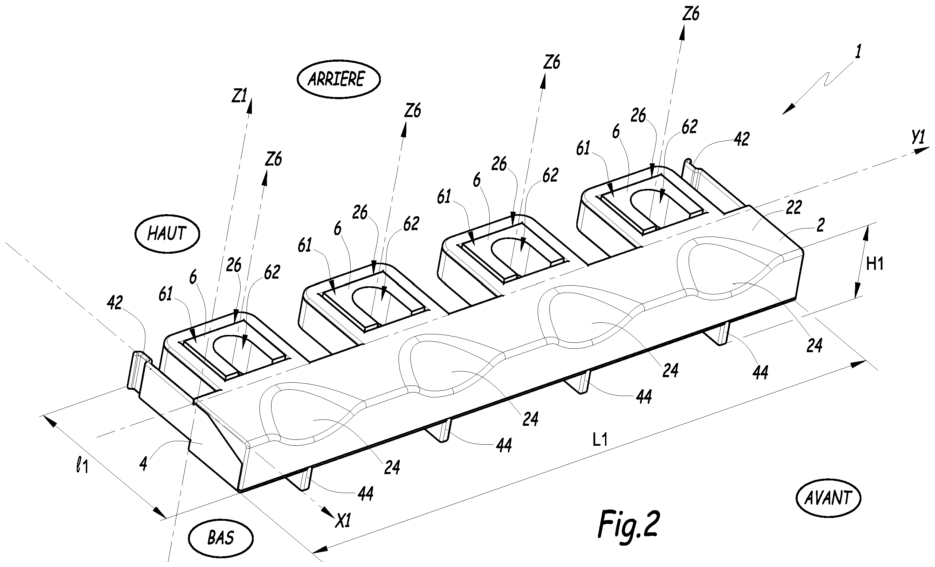

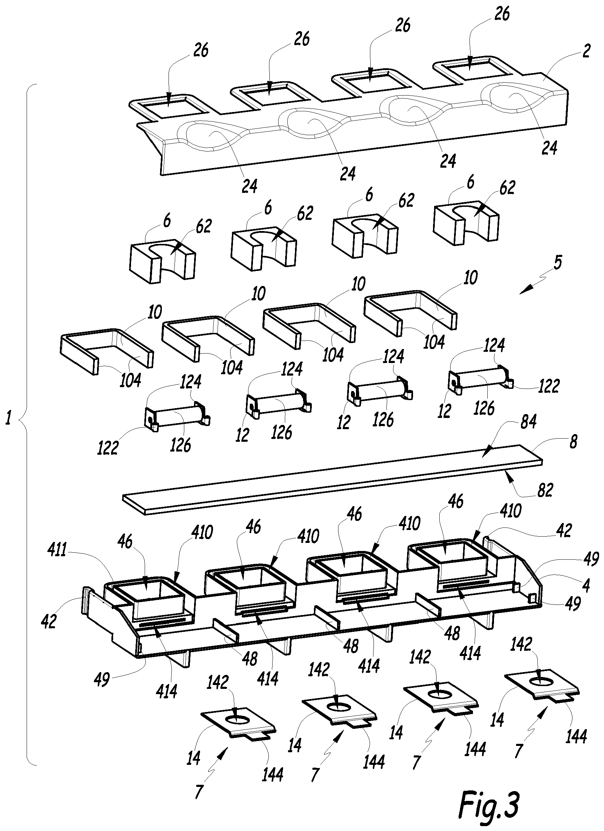

La figure 2 représente le dispositif de mesure 1, celui-ci comprenant un capot de protection 2 venant recouvrir un boîtier 4. Le dispositif de mesure 1 comprend également au moins un capteur de courant 5, visible en vue éclatée sur la figure 3, et au moins une entretoise 6 électriquement conductrice, adaptée pour être interposée entre une borne de connexion de l'appareil électrique et l'extrémité d'un conducteur électrique destiné à être relié électriquement à ladite borne de connexion. Le capteur de courant 5 est disposé autour d'une entretoise correspondante 6 et est adapté pour mesurer le courant circulant à travers ladite entretoise 6, entre le conducteur électrique et la borne de connexion correspondante.

En complément facultatif, le dispositif de mesure 1 comprend au moins un capteur de tension 7, disposé contre une entretoise correspondante 6 et adapté pour mesurer la tension en la borne de connexion correspondante.

Le dispositif de mesure 1 étant adapté à être monté sur le disjoncteur D tétrapolaire, il comporte alors de préférence quatre capteurs de courant 5 et quatre entretoises 6. En complément facultatif, le dispositif de mesure 1 comprend quatre capteurs de tension 7.

Le dispositif de mesure 1 a globalement une forme de parallélépipède rectangle. On note Y1 une direction transversale parallèle au plus grand côté de ce parallélépipède rectangle et Z1 une direction verticale parallèle au plus petit côté de ce parallélépipède. On note également X1 une direction longitudinale perpendiculaire aux axes Y1 et Z1. La direction Z1 est orientée de bas en haut, la direction X1 est orientée d'arrière en avant, et la direction Y1 est orientée de droite à gauche.

On note L1 la longueur du dispositif de mesure 1, mesurée selon la direction Y1, ℓ1 sa largeur, mesurée selon la direction X1 et H1 sa hauteur, mesurée selon la direction Z1. En pratique et à titre d'exemple, la longueur L1 est comprise entre 100 mm et 200 mm, de préférence sensiblement égale à la largeur de l'appareil électrique selon la même direction Y1, par exemple 150 mm. La largeur ℓ1 est, par exemple, comprise entre 20 mm et 30 mm, et la hauteur H1 est comprise entre 10 mm et 20 mm, de préférence égale à 15 mm. Le dispositif de mesure 1 est alors particulièrement peu encombrant, ce qui facilite son raccordement à l'appareil électrique.

Dans un premier mode de réalisation de l'invention, représenté dans les figures 1 à 5, chaque capteur de courant 5 comporte un circuit magnétique 10 et une bobine 12, la bobine 12 étant disposée entre deux extrémités 104 du circuit magnétique. Le dispositif de mesure 1 comprend alors quatre bobines 12, chacune étant associée à une entretoise 6 respective. Les bobines 12 sont maintenues en place sur un circuit imprimé 8 par des moyens de fixation 122. Les bobines 12 comportent chacune un enroulement 126 disposé entre deux extrémités 124 en forme de languettes de contact.

Les entretoises 6 sont reçues dans le boîtier 4 et dépassent du capot 2. Le boîtier 4 et le capot 2 sont réalisés en un matériau isolant, tandis que les entretoises 6 sont réalisées dans un matériau électriquement conducteur ayant de préférence une bonne conductivité, tel que le cuivre.

Les entretoises 6 ont une section de passage du courant, définie selon un plan perpendiculaire à la direction Z1, qui est dimensionnée en fonction du courant nominal de l'appareil électrique et de l'échauffement à ne pas dépasser pour l'appareil électrique, tel que le disjoncteur, auquel le dispositif de mesure 1 est destiné à être connecté. En pratique et à titre d'exemple, pour un appareil électrique dont le courant nominal est de 250 A, la section de passage sera comprise entre 10 et 20 mm². Ainsi, le passage du courant dans l'entretoise 6 ne génère pas d'échauffement excessif. La section de chaque entretoise 6 est, par exemple, en forme de fer à cheval.

Les entretoises 6 comprennent un orifice 62 de passage d'une vis de connexion, la vis de connexion étant destinée à fixer, à l'appareil électrique, à la fois le dispositif de mesure 1 et l'extrémité du conducteur électrique, telle qu'une cosse, qui est destinée à être reliée électriquement à l'appareil électrique via le dispositif de mesure 1.

Les entretoises 6 sont de préférence toutes identiques et s'étendent selon la direction verticale Z1. Les entretoises 6 sont décalées et régulièrement espacées les unes des autres selon la direction longitudinale X1. Elles sont toutes orientées dans la même direction, de telle sorte que l'ouverture de chaque fer à cheval se trouve dirigée vers l'avant du dispositif de mesure 1.

Les entretoises 6 sont reçues dans quatre orifices débouchants 46 ménagés à cet effet dans le boîtier 4. Les orifices 46 du boîtier 4, prévus pour recevoir les entretoises 6 présentent, sur leur bord intérieur avant, des bossages 47 permettant d'orienter et de maintenir en position les entretoises 6.

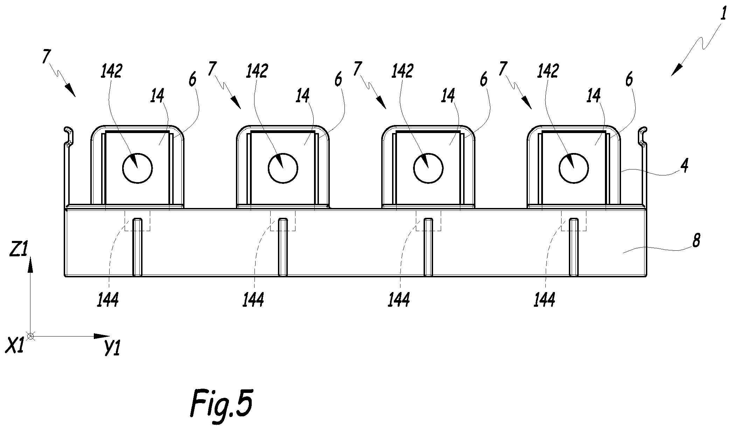

Dans le mode de réalisation des figures 1 à 5, chaque capteur de tension 7 est en forme d'une languette 14 de prise de tension. Chaque languette 14 comporte un orifice 142 permettant le passage de la vis de connexion, destinée également à traverser les entretoises 6 et venant fixer à la fois la cosse du conducteur électrique et le dispositif de mesure 1 à la borne de connexion correspondante de l'appareil. Les languettes 14 comportent également une extrémité 144 de liaison électrique avec le circuit imprimé 8. La figure 5 illustre la connexion des lames métalliques 14 au circuit imprimé 8. Les extrémités 144 de liaison électrique des languettes 14 chevauchent le circuit imprimé 8 et y sont fixées.

Le circuit imprimé 8 comporte une face inférieure 82 sur laquelle sont réalisées les connexions électriques des bobines 12 et des languettes de prise de tension 14. Au cours de l'utilisation du dispositif de mesure 1, un courant alternatif présentant une fréquence par exemple égale à 50 Hz parcourt les entretoises 6. Les variations du courant génèrent un champ magnétique qui, par l'intermédiaire du circuit magnétique crée une différence de potentiel dans la bobine 12. La bobine 12 est ainsi parcourue par un courant destiné à alimenter le circuit imprimé 8.

Le circuit imprimé 8 comporte une face supérieure 84, et des microcontrôleurs, non représentés, connectés sur la face supérieure 84. Les microcontrôleurs permettent de réaliser, entre autres, le calcul d'énergies électriques, de puissances électriques et d'harmoniques de courant pour chaque phase et pour le neutre, à partir du ou des courants mesurés, ainsi que du ou des tensions mesurées.

En complément, le circuit imprimé 8 comprend des moyens radioélectriques, non représentés, de transmission de la ou des grandeurs électriques mesurées, telles que l'intensité mesurée par le capteur de courant 5 et la tension mesurée par le capteur de tension 7. Les moyens radioélectriques de transmission comportent, par exemple, une antenne et un émetteur-récepteur radioélectrique. L'émetteur-récepteur est adapté pour transmettre les grandeurs mesurées à un récepteur distant, via un signal radioélectrique, tel qu'un signal conforme à la norme WIFI ou ZIGBEE.

Les composants électroniques du circuit imprimé 8 sont prévus pour fonctionner normalement à une température de 105°C.

Les circuits magnétiques 10 sont en forme de U. Les deux extrémités 104 de chaque circuit magnétique 10 sont en appui contre les deux extrémités 124 d'une bobine 12.

Le capot 2 comporte, sur sa partie avant, une plage 22 comprenant des creux 24 permettant de faciliter le montage de cosses, fixées à l'extrémité de conducteurs électriques, sur une face supérieure 61 de chaque entretoise 6.

Le boîtier 4 comprend des crochets 42 permettant de fixer par emboitage élastique le dispositif de mesure 1 au disjoncteur D. Le boîtier 4 comprend également des nervures de détrompage 44 empêchant son installation dans un sens autre que celui prévu par le fabriquant. Ces nervures 44 fixées à la face inférieure du boîtier 4 sont au nombre de quatre et sont régulièrement espacées. Par ailleurs, elles sont orientées selon la direction longitudinale X1.

Le boîtier 4 comporte également des rebords transversaux 48 et des rebords longitudinaux 49 adaptés pour soutenir le circuit imprimé 8. Ces rebords 48 et 49 permettent de surélever le circuit imprimé 8 de manière à, éventuellement, fixer des composants sur sa face inférieure 82 et d'éviter un échauffement excessif pouvant endommager le circuit imprimé 8.

Le boîtier 4 comprend un nombre prédéterminé de rainures 410 permettant de disposer les circuits magnétiques 10, chacun autour d'une entretoise 6 respective. Le nombre de rainures 410, respectivement de circuits magnétiques 10, est égal au nombre de pôles de l'appareil électrique, tel que le disjoncteur, auquel le dispositif de mesure 1 est destiné à être connecté. Une paroi 411 du boîtier 4 est disposée à l'intérieur de chaque circuit magnétique 10 et entoure chaque entretoise 6, assurant ainsi une isolation électrique entre chaque circuit magnétique et l'entretoise 6 correspondante.

Le boîtier 4 comporte également des fentes 414 dont les dimensions sont adaptées pour permettre le passage des languettes 14 servant à effectuer la mesure de tension.

Le dispositif de mesure 1 s'adapte ainsi facilement sur des installations déjà existantes et nécessitant une remise à niveau.

Lors d'une première étape d'installation, le dispositif de mesure 1 est emboîté sur la face avant du disjoncteur et les crochets 42 du dispositif de mesure 1 viennent s'accrocher, de manière élastique, sur des bords de l'appareil électrique, tel que le disjoncteur. Ces crochets 42 permettent alors de fixer le dispositif de mesure 1 au disjoncteur. Une deuxième étape consiste à faire passer, pour chaque entretoise 6, une vis de connexion à travers un orifice de la cosse du conducteur électrique correspondant, à travers l'orifice 62 de l'entretoise 6 correspondante et à travers l'orifice 142 de la languette de prise de tension 14 correspondante avant de serrer cette vis sur la borne de connexion correspondante du disjoncteur.

Les vis de connexion concourent à la liaison électrique entre la borne de connexion du disjoncteur et la cosse du conducteur électrique, en assurant une forte pression mécanique entre ces pièces.

Ainsi, une seule étape permet, à la fois, de relier électriquement et mécaniquement le conducteur électrique à la borne de connexion du disjoncteur et de fixer le dispositif de mesure 1 au disjoncteur.

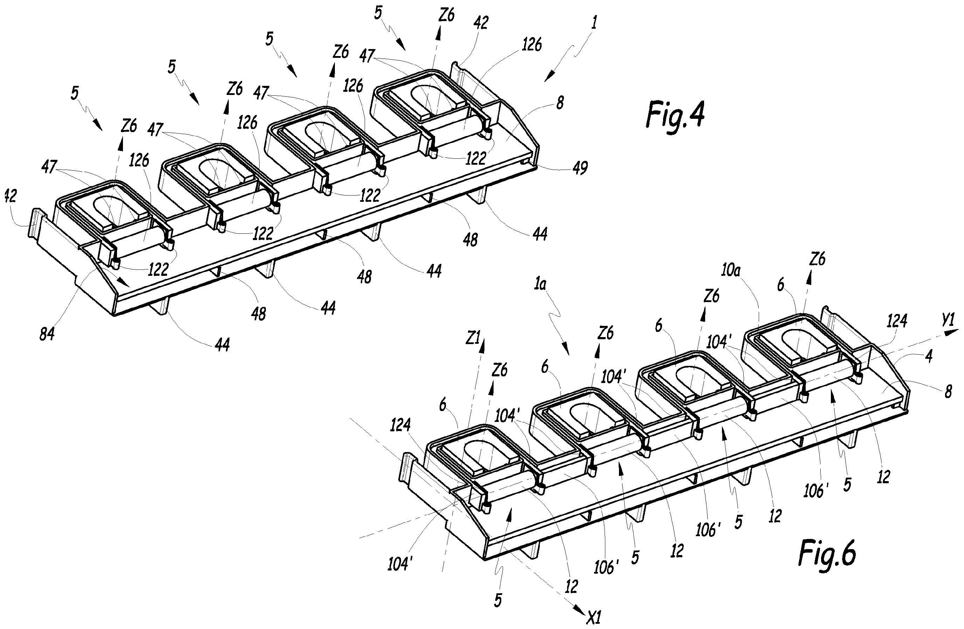

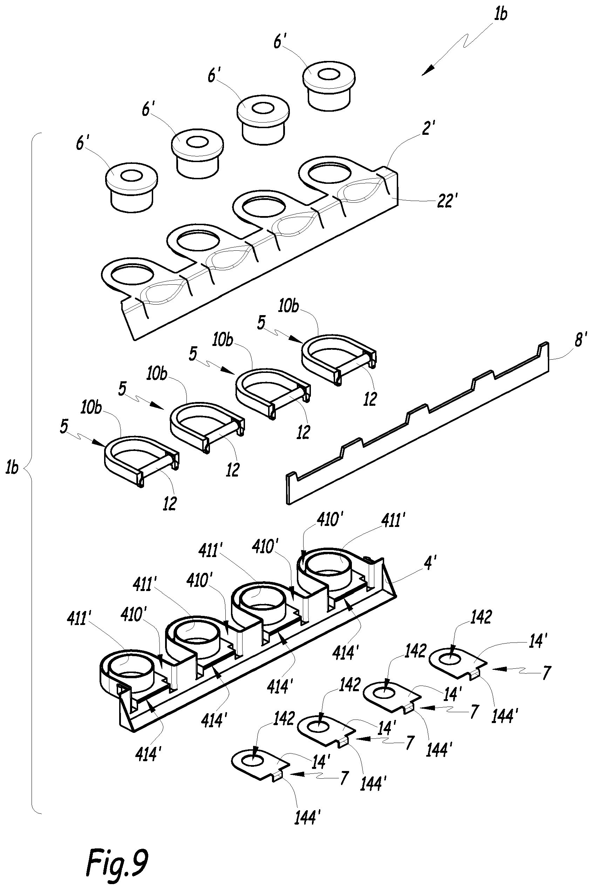

Dans les modes de réalisation représentés sur les figures 6 à 10, les éléments analogues à ceux du premier mode de réalisation portent les mêmes références et ne sont pas décrits à nouveau.

Dans un deuxième mode de réalisation de l'invention, représenté à la figure 6, le champ magnétique généré par les variations de courants dans l'entretoise 6 d'un dispositif de mesure 1a est capté par un seul circuit magnétique 10a, en forme de boustrophédon. Autrement dit, l'unique circuit magnétique 10a a une forme crénelée, c'est-à-dire une forme en zigzag.

Le circuit magnétique 10a entoure chaque entretoise 6, comme décrit précédemment. Il entoure les faces arrière et latérales de chaque entretoise 6 et une bobine 12 est disposée en regard de la face avant de chaque entretoise 6. Le circuit magnétique 10a a une forme composée de quatre U, chacun étant semblable au circuit magnétique 10 décrit précédemment. Les quatre U sont alignés selon la direction longitudinale X1, et les ouvertures des U étant dirigées vers l'avant. Les quatre U sont reliés entre eux par trois barres de liaison 106'. Les extrémités intérieures 104' de chaque pièce en U sont connectées chacune à une plaquette 124 de liaison avec les bobines 12.

Le circuit magnétique 10a est plus économique à réaliser industriellement que les circuits magnétiques 10 et présente une meilleure tenue mécanique. Il est réalisable soit sous forme de pièce frittée, soit sous forme de tôles découpées et empilées les unes sur les autres.

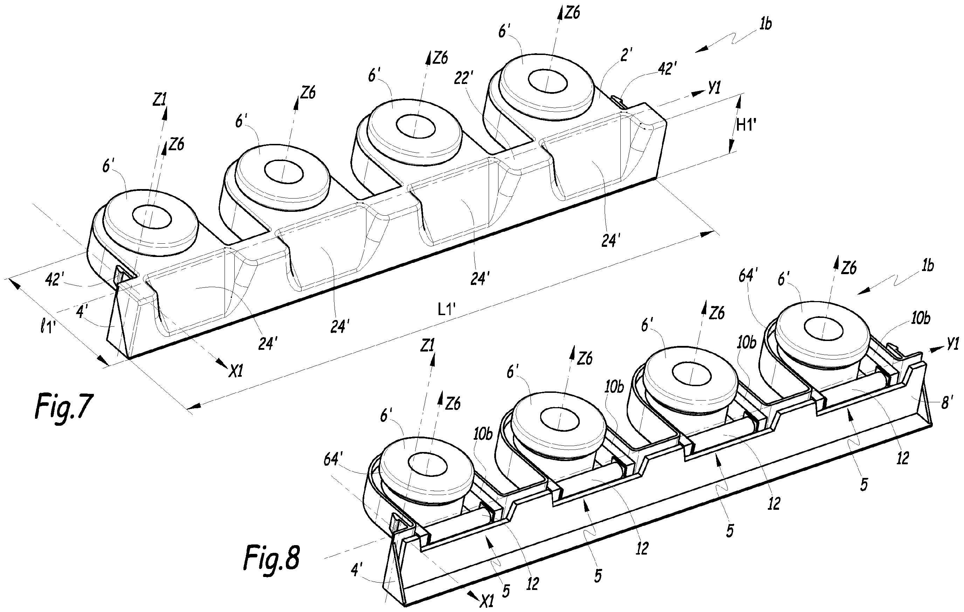

Dans un troisième mode de réalisation représenté dans les figures 7 à 9, la plage 22' du capot de protection est plus étroite, et on note ℓ*1*' la largeur, L1' la longueur et H1' la hauteur du dispositif de mesure 1 b selon ce troisième mode de réalisation. La largeur ℓ1' du dispositif de mesure 1 b est inférieure à la largeur ℓ1 du dispositif de mesure 1 selon le premier mode de réalisation et la longueur L1' du dispositif de mesure 1b est sensiblement identique à la longueur L1 du dispositif de mesure 1 selon le premier mode de réalisation, tandis que la hauteur H1' est supérieure à la hauteur H1 du dispositif de mesure 1 selon le premier mode de réalisation. En pratique, la longueur L1' est de préférence sensiblement égale à la largeur de l'appareil électrique selon la même direction Y1, par exemple comprise entre 100 et 200 mm, par exemple 185 mm. La largeur ℓ1' est, par exemple, comprise entre 20 et 40 mm et la hauteur H1' est comprise entre 20 et 40 mm. Là encore, le dispositif de mesure 1 est également particulièrement peu encombrant, ce qui facilite son raccordement à l'appareil électrique.

La plage 22' comporte des creux 24', similaires aux creux 24 du dispositif de mesure 1. Les creux 24' du dispositif de mesure 1b sont plus profonds que les creux 24 du dispositif de mesure 1. Il est ainsi possible de fixer, sur la face supérieure 61 des entretoises 6, des cosses de conducteurs électriques de plus gros diamètre que dans le premier mode de réalisation. Il est également possible, de connecter deux cosses tête-bêche sur une même entretoise 6. Par ailleurs, les crochets de fixation 42 sont situés plus vers l'avant du dispositif de mesure 1.

Dans ce troisième mode de réalisation, les entretoises 6' ne sont plus en forme de fer à cheval, mais en forme de cylindre de révolution, autour d'un axe vertical Z6. Les entretoises 6 comportent à leur extrémité supérieure un épaulement 64' de telle sorte que leur extrémité supérieure présente un diamètre supérieur au reste de l'entretoise. Ainsi, l'entretoise est en butée contre le capot 2' et ne peut pas glisser vers le bas selon l'axe vertical Z6.

Par ailleurs, dans ce troisième mode de réalisation, des circuits magnétiques 10b viennent entourer les entretoises 6' et présentent une forme partiellement arrondie, de manière à épouser au mieux la forme des entretoises 6'.

Les bobines 12 sont identiques au mode de réalisation précédent.

Comme précédemment, le boîtier 4' comprend, autour de chaque entretoise 6', une rainure 410' adaptée pour recevoir l'un des circuits magnétiques 10b. Des parois 411' assurent l'isolation électrique entre chaque entretoise 6' et l'un des circuits magnétiques 10b. Le boîtier 4' comporte également des fentes 414' dont la taille est adaptée au passage de languettes 14' pour la prise de tension. Les languettes 14', ont une forme partiellement arrondie adaptée à la forme des entretoises 6' et du boîtier 4'. Comme précédemment, les languettes 14' comprennent une extrémité 144' permettant de les connecter à un circuit imprimé 8', et un orifice 142 permettant le passage d'une vis de connexion, la vis étant adaptée pour connecter la cosse du conducteur électrique et le dispositif de mesure 1 b à la borne de connexion correspondante de l'appareil électrique.

Dans ce mode de réalisation, le circuit imprimé 8' est disposé verticalement, suivant un plan parallèle aux directions transversale Y1 et verticale Z1. Les éléments de puissance électrique, tels que les languettes de prise de tension 14', et les bobines 12 sont connectées sur une face arrière du circuit imprimé 8', tandis que les composants électriques permettant d'effectuer les calculs, le traitement du signal, et la transmission des données se trouvent sur une face avant du circuit imprimé 8'.

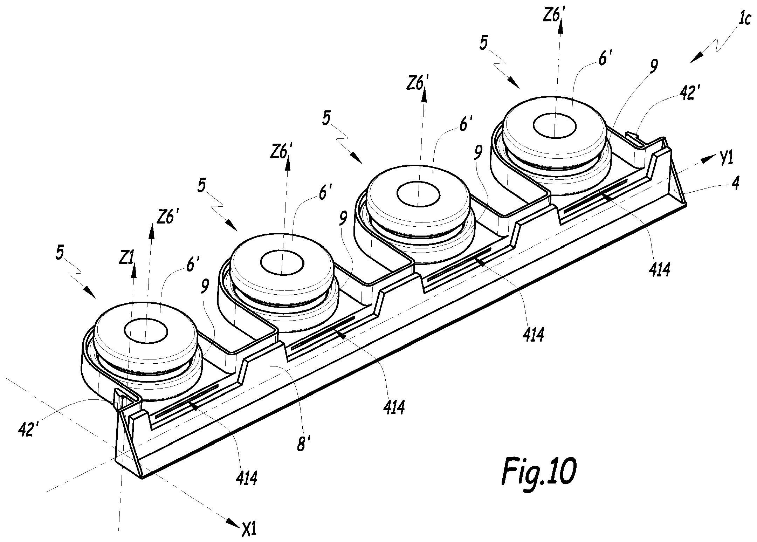

Dans un quatrième mode de réalisation du dispositif de mesure 1c, représenté à la figure 10, les capteurs de courant 5 comportant les circuits magnétiques 10b et les bobines 12 du troisième mode de réalisation sont remplacés par des capteurs de courant 5 en forme de tores 9. Chaque capteur de courant 5 du dispositif de mesure 1c est, par exemple, en forme d'un tore de Rogowski.

Comme dans le troisième mode de réalisation, les entretoises 6' sont cylindriques, et chacune d'elles est entourée d'une paroi 411' assurant l'isolation électrique. Chaque tore 9 est disposé autour de chaque entretoise 6', dans une rainure 410' correspondante. La connexion électrique des tores 9 au circuit imprimé 8' est similaire à la connexion des bobines 12 au circuit imprimé 8, décrite précédemment.

Dans un cinquième mode de réalisation, non représenté, le capteur de courant 5 en forme de tore 9, tel que le tore du quatrième mode de réalisation, est associé aux autres éléments du dispositif de mesure 1 selon le premier mode de réalisation. Ainsi, les entretoises 6 ont une forme adaptée, notamment une forme cylindrique. De même, le capot 2 et le boîtier 4 ont une forme adaptée au passage de l'entretoise cylindrique 6 et à l'installation du capteur de courant 5 en forme de tore. Comme pour le quatrième mode de réalisation, chaque capteur de courant 5 en forme de tore 9 remplace le circuit magnétique 10 et la bobine 12 correspondante.

Dans un sixième mode de réalisation, non représenté, le circuit magnétique 10a, en forme de boustrophédon, du deuxième mode de réalisation, est associé au capot 2' et au boîtier 4' du troisième mode de réalisation. Ainsi, les circuits magnétiques 10b sont remplacés par un seul circuit magnétique 10a.

Dans d'autres modes de réalisation de l'invention, le dispositif de mesure est destiné à mesurer des grandeurs électriques d'un courant parcourant un disjoncteur monophasé ou encore triphasé. Ainsi, le dispositif de mesure comprend généralement de 1 à 4 entretoises, semblables à celles décrites précédemment, et à chacune d'elles sont associés un capteur de courant 5 et un capteur de tension 7. Le ou chaque capteur de courant 5 est soit un tore de Rogowski 9, soit un circuit magnétique 10 associé à une bobine 12, les circuits magnétiques 10 étant par exemple constitués par une unique pièce en forme de boustrophédon. Le ou chaque capteur de tension 7 comporte une languette en contact avec la ou chaque entretoise 6. Le ou chaque capteur de courant 5 et de tension 7 sont connectés au circuit imprimé 8 comprenant également des moyens de calcul, à partir de l'intensité de la tension mesurées, de grandeurs électriques, telle que l'énergie électrique, la puissance électrique, et les harmoniques du courant, ainsi que des moyens radioélectriques de transmission des grandeurs mesurées et calculées.

Dans la description ci-dessus et les figures l'appareil électrique est représenté par un disjoncteur cependant l'appareil électrique peut être aussi un autre appareil de coupure tel qu'interrupteur, un contacteur ou un sectionneur. Il peut être également un appareil de protection électrique tel qu'un relais de protection de surcharge, de court-circuit ou différentielle. Dans d'autres cas l'appareil électrique peut être aussi un module auxiliaire d'un autre appareil électrique tel qu'un bornier ou un dispositif de connexion déporté.

## Revendications

1. Dispositif de mesure (1, 1a, 1b, 1c) d'au moins une grandeur électrique d'un courant destiné à circuler dans un appareil électrique (D), l'appareil électrique comprenant au moins une borne de connexion, la ou chaque borne de connexion étant destinée à être reliée électriquement à l'extrémité d'un conducteur électrique correspondant, le dispositif de mesure comprenant au moins un capteur de courant (5), le ou chaque capteur de courant étant adapté pour mesurer le courant circulant dans un conducteur électrique correspondant, **caractérisé en ce qu'**il comprend en outre au moins une entretoise (6, 6') électriquement conductrice, la ou chaque entretoise (6,6') étant adaptée pour être interposée entre une borne de connexion respective et l'extrémité d'un conducteur électrique correspondant, et **en ce que** chaque capteur de courant (5) est en outre disposé autour d'une entretoise (6,6') respective, pour mesurer le courant circulant à travers ladite entretoise (6,6'), entre le conducteur électrique et la borne de connexion correspondante.

2. Dispositif (1, 1a, 1b, 1c) selon la revendication 1, dans lequel l'appareil électrique comprend N bornes de connexion, N étant un nombre entier supérieur ou égal à 2, et dans lequel le dispositif de mesure comprend N capteurs de courant (5) et N entretoises (6, 6').

3. Dispositif (1, 1a, 1b) selon l'une des revendications précédentes, dans lequel au moins un capteur de courant (10, 10b, 12) comporte un circuit magnétique (10, 10a, 10b) et une bobine (12), la bobine étant disposée entre deux extrémités (104) du circuit magnétique.

4. Dispositif (1a) selon les revendications 2 et 3, dans lequel les circuits magnétiques sont formés par une unique pièce (10a) en forme de boustrophédon.

5. Dispositif (1c) selon l'une des revendications précédentes, dans lequel au moins un capteur de courant (5) comporte un enroulement bobiné (9) en forme de tore, tel qu'un tore de Rogowski.

6. Dispositif (1, 1a, 1b, 1c) selon l'une des revendications précédentes, dans lequel le dispositif comprend au moins un capteur de tension (7) adapté pour mesurer la tension d'une borne de connexion correspondante.

7. Dispositif (1, 1a, 1b, 1c) selon la revendication 6, dans lequel le ou chaque capteur de tension (7) est en forme d'une languette (14, 14') disposée contre une entretoise (6, 6') respective.

8. Dispositif (1, 1a, 1b, 1c) selon l'une des revendications précédentes, dans lequel la ou chaque entretoise (6, 6') comporte un orifice de passage d'un organe de connexion de l'extrémité du conducteur à la borne de connexion correspondante.

9. Dispositif (1, 1a, 1b, 1c) selon l'une des revendications précédentes, dans lequel le dispositif comprend des moyens radioélectriques de transmission de la ou des grandeurs électriques mesurées à un équipement électronique distant dudit dispositif.

10. Dispositif (1, 1a, 1b, 1c) selon l'une des revendications précédentes, dans lequel le dispositif comporte des moyens d'emboîtage élastique (42, 42') avec des moyens complémentaires de l'appareil électrique, pour fixer le dispositif à l'appareil électrique.

11. Ensemble (E) comprenant un appareil électrique (D), et un dispositif de mesure (1, 1a, 1b, 1c) d'au moins une grandeur électrique d'un courant destiné à circuler dans l'appareil électrique, **caractérisé en ce que** le dispositif de mesure (1, 1a, 1b, 1c) est conforme à l'une quelconque des revendications précédentes.

12. Ensemble (E) selon la revendication 11, dans lequel l'appareil électrique est un appareil de coupure électrique ou de protection électrique.

13. Ensemble (E) selon l'une des revendications 11 ou 12, dans lequel l'appareil électrique est un disjoncteur électrique.

## Patentansprüche

1. Vorrichtung (1, 1a, 1b, 1c) zum Messen mindestens einer elektrischen Größe eines Stroms, der vorgesehen ist, in einem elektrischen Gerät (D) zu fließen, wobei das elektrische Gerät mindestens eine Anschlussklemme umfasst, wobei die oder jede Anschlussklemme vorgesehen ist, elektrisch mit einem Ende eines korrespondierenden elektrischen Leiters verbunden zu werden, wobei die Messvorrichtung mindestens einen Stromsensor (5) aufweist, wobei der oder jeder Stromsensor geeignet ist, den in einem korrespondierenden elektrischen Leiter fließenden Strom zu messen, **dadurch gekennzeichnet, dass** sie außerdem mindestens ein elektrisch leitendes Abstandsstück (6, 6') umfasst, wobei das oder jedes Abstandsstück (6, 6') dazu dient, zwischen eine jeweilige Verbindungsklemme und dem Ende eines korrespondierenden elektrischen Leiters angeordnet zu werden, und dass jeder Stromsensor (5) außerdem um ein jeweiliges Abstandsstück (6, 6') herum angeordnet ist, um den durch das Abstandsstück (6, 6') zwischen dem elektrischen Leiter und der korrespondierenden Verbindungsklemme fließenden Strom zu messen.

2. Vorrichtung (1, 1a, 1b, 1c) nach Anspruch 1, bei der das elektrische Gerät N Anschlussklemmen umfasst, wobei N eine ganze Zahl größer oder gleich 2 ist, und bei der die Messvorrichtung N Stromsensoren (6) und N Abstandsstücke (6, 6') umfasst.

3. Vorrichtung (1, 1a, 1b, 1c) nach einem der vorhergehenden Ansprüche, bei der mindestens ein Stromsensor (10, 10b, 12) einen Magnetkreis (10, 10a, 10b) und eine Spule (12) aufweist, wobei die Spule zwischen zwei Enden (104) des Magnetkreises angeordnet ist.

4. Vorrichtung (1, 1a, 1b, 1c) nach den Ansprüchen 2 und 3, bei der die Magnetkreise als ein einziges Stück (10a) in Bustrophedonform ausgebildet sind.

5. Vorrichtung (1, 1a, 1b, 1c) nach einem der vorhergehenden Ansprüche, bei der mindestens ein Stromsensor (5) eine Wicklung (9) in Torusform, wie einen Rogowski-Torus aufweist.

6. Vorrichtung (1, 1a, 1b, 1c) nach einem der vorhergehenden Ansprüche, bei der die Vorrichtung mindestens einen Spannungssensor (7) umfasst, der geeignet ist, die Spannung einer korrespondierenden Anschlussklemme zu messen.

7. Vorrichtung (1, 1a, 1b, 1c) nach Anspruch 6, bei der der oder jeder Spannungssensor (7) in Form einer Zunge (14, 14') ausgebildet ist, die gegen ein jeweiliges Abstandsstück (6, 6') angeordnet ist.

8. Vorrichtung (1, 1a, 1b, 1c) nach einem der vorhergehenden Ansprüche, bei der das oder jedes Abstandsstück (6, 6') eine Durchgangsöffnung für ein Element zur Verbindung des Endes des Leiters mit der korrespondierenden Anschlussklemme aufweist.

9. Vorrichtung (1, 1a, 1b, 1c) nach einem der vorhergehenden Ansprüche, bei der die Vorrichtung Funkmittel zur Übertragung der gemessenen elektrischen Größe(n) an eine elektronische Einrichtung entfernt zu der Vorrichtung aufweist.

10. Vorrichtung (1, 1a, 1b, 1c) nach einem der vorhergehenden Ansprüche, bei der die Vorrichtung Mittel (42, 42') zum elastischen Einschieben in komplementäre Mittel des elektrischen Geräts zum Befestigen der Vorrichtung an dem elektrischen Gerät aufweist.

11. Anordnung (E), ein elektrisches Gerät (D) und eine Vorrichtung (1, 1a, 1b, 1c) zum Messen mindestens einer elektrischen Größe eines Stroms, der in dem elektrischen Gerät fließt, umfassend **dadurch gekennzeichnet, dass** die Messvorrichtung (1, 1a, 1b, 1c) nach einem beliebigen der vorhergehenden Ansprüche ausgebildet ist.

12. Anordnung (E) nach Anspruch 11, bei der das elektrische Gerät ein elektrisches Abschaltgerät oder ein elektrisches Schutzgerät ist.

13. Anordnung (E) nach einem der Ansprüche 11 oder 12, bei der das elektrische Gerät ein Sicherungsschalter ist.

## Claims

1. A device (1, 1 a, 1b, 1c) for measuring at least one electrical variable of a current intended to flow in an electric apparatus (D), the electric apparatus comprising at least one connection terminal, the or each connection terminal being designed to be electrically connected to the end of a corresponding electric conductor, the measuring device comprising at least one current sensor (5), the or each current sensor being adapted for measuring the current flowing in a corresponding electric conductor, **characterized in that** it further comprises at least one electrically conductive spacer (6, 6'), the or each spacer (6, 6') being configured for being interposed between a respective connection terminal and the end of a corresponding electric conductor, and **in that** each current sensor (5) is further positioned around a respective spacer (6, 6'), to measure the current flowing through said spacer (6, 6'), between the electric conductor and the corresponding connection terminal.

2. The device (1, 1a, 1b, 1c) according to claim 1, wherein the electric apparatus comprises N connection terminals, N being an integer greater than or equal to 2, and wherein the measuring device comprises N current sensors (5) and N spacers(6, 6').

3. The device (1, 1a, 1b) according to any one of the preceding claims, wherein at least one current sensor (10, 10b ,12) comprises a magnetic circuit (10, 10a ,10b) and a coil (12), the coil being positioned between two ends (104) of the magnetic circuit.

4. The device (1a) according to claims 2 and 3, wherein the magnetic circuits are formed by a single piece (10a) in the form of a boustrophedon.

5. The device (1c) according to any one of the preceding claims, wherein at least one current sensor (5) comprises a winding coiled (9) in the shape of a toroid, such as a Rogowski toroid.

6. The device (1, 1a, 1b, 1c) according to any one of the preceding claims, wherein the device comprises at least one voltage sensor (7) configured for measuring the voltage of a corresponding connection terminal.

7. The device (1, 1a, 1b, 1c) according to claim 6, wherein the or each voltage sensor (7) is in the form of a tongue (14, 14') positioned against a respective spacer (6, 6').

8. The device (1, 1a, 1b, 1c) according to any one of the preceding claims, wherein the or each spacer (6, 6') comprises a passage orifice for a connection member connecting the end of the conductor to the corresponding connection terminal.

9. The device (1, 1a, 1b, 1c) according to any one of the preceding claims, wherein the device comprises radio means for sending the measured electrical variable(s) to an electronic equipment that is remote from said device.

10. The device (1, 1a, 1b, 1c) according to any one of the preceding claims, wherein the device comprises elastic fitting means (42, 42') for fitting with complementary means of the electric apparatus, to fasten the device to the electric apparatus.

11. An assembly (E) comprising an electric apparatus (D), and a device (1, 1a, 1b, 1c) for measuring at least one electric variable of a current intended to flow in the electric apparatus, **characterized in that** the measuring device (1, 1a, 1b, 1c) is according to any one of the preceding claims.

12. The assembly (E) according to claim 11, wherein the electric apparatus is an electric cutoff apparatus or an electric protection apparatus.

13. The assembly (E) according to claim 11 or 12, wherein the electric apparatus is an electric circuit breaker.
